# EUROPEAN PATENT APPLICATION

(11) **EP 4 783 800 A1**
(43) Date of publication of application: **29.07.2026**
(21) Application number: 25224507.1
(22) Date of filing: 17.12.2025
(51) Int. Cl.: H10K 59/131, H10K 59/65, H10K 59/70

(54) **DISPLAY DEVICE**

(30) Priority: 24.01.2025 KR 20250011735
(71) Applicant: LG Display Co., Ltd., Seoul, 07336 (KR)
(72) Inventor: KANG, Minji, 10845 Paju-si (KR); PARK, Jeongmin, 10845 Paju-si (KR)
(74) Representative: Poll, Christopher

(57) **Abstract**

A display device according to embodiments of the present disclosure includes a display panel including a display area with a plurality of pixels, an optical hole within the display area, and a hole bezel area surrounding the optical hole, a plurality of scan lines extending in a first direction in the display area and disconnected by the optical hole, a plurality of bypass connection lines disposed in the display area, the plurality of bypass connection lines connecting disconnected portions of the plurality of scan lines, and a plurality of data lines extending in a second direction in the display area and passing through the hole bezel area, the second direction intersecting the first direction.

## Description

### Technical Field

The present disclosure relates to a display device.

### Description of the Related Art

Display devices are used in various electronic devices such as TVs, smartphones, laptops, and tablets.

They include self-emissive organic light-emitting displays (OLEDs) and liquid crystal displays (LCDs), which require a separate light source.

In addition to displaying images, display devices may incorporate sensors and cameras for object detection or image capturing.

Recently, to reduce the bezel area, display devices with optical holes formed in the display area to accommodate sensors and cameras have been developed.

### SUMMARY

As an optical hole is provided within the display area of the display panel, signal lines are designed to bypass the optical hole through a hole bezel region surrounding the optical hole. In the hole bezel region, gate lines (including scan lines and emission control lines) and data lines are densely arranged.

The gate lines are arranged to be separated above and below the center line of the optical hole. If misalignment occurs during manufacturing, a difference arises between a parasitic capacitance between the upper gate lines and data lines located above the center line and a parasitic capacitance between the lower gate lines and data lines located below the center line. This results in a parasitic capacitance step across the center line of the optical hole. This difference in parasitic capacitance causes the kickback voltage of the upper gate line to be different from that of the lower gate line. As a result, a luminance difference may occur in the display area based on the center line of the optical hole.

It is an object of the present disclosure to provide a display device capable of improving luminance uniformity in the display area around the optical hole.

It is another object of the present disclosure to provide a display device capable of reducing production energy and greenhouse gas emissions.

The objects of the present disclosure are not limited to those described above, and other objects not explicitly stated will be readily understood by those skilled in the art from the following description.

A display device according to embodiments of the present disclosure includes a display panel including a display area with a plurality of pixels, an optical hole within the display area, and a hole bezel area surrounding the optical hole, a plurality of scan lines extending in a first direction in the display area and disconnected by the optical hole, a plurality of bypass connection lines disposed in the display area, connecting disconnected portions of the plurality of scan lines, and a plurality of data lines extending in a second direction intersecting the first direction in the display area and passing through the hole bezel area.

A display device according to embodiments of the present disclosure includes a display panel including a display area with a plurality of pixels, an optical hole within the display area, and a hole bezel area surrounding the optical hole, and a plurality of scan lines that supply a scan signal to the plurality of pixels, a first part of a first scan line of the plurality of scan lines extending in a first direction, a second part of the first scan line extending in the first direction and a second direction, and the second part of the first scan line being routed around the hole bezel area.

According to embodiments of the present disclosure, the first part of the first scan line and the second part of the first scan line are routed above a centerline of the optical hole, a first part of a second scan line of the plurality of scan lines extends in the first direction, a second part of the second scan line extends in the first direction and the second direction, the second part of the second scan line is routed around the hole bezel area and below the centerline of the optical hole, and the second part of the first scan line and the second part of the second scan line are symmetrically routed relative to the centerline of the optical hole.

According to embodiments of the present disclosure, a first part of a second scan line of the plurality of scan lines extends in the first direction, a second part of the second scan line extends in the first direction, and the second part of the second scan line is routed through the hole bezel area and around the optical hole.

According to embodiments of the present disclosure, the second part of the first scan line includes a first bypass portion extending in the second direction and a second bypass portion extending in the first direction.

According to embodiments of the present disclosure, the display device further includes a plurality of data lines that supply data voltages to the plurality of pixels. A first data line of the plurality of data lines includes a first part extending in the second direction and routed outside of the hole bezel area, and the first data line further includes a second part routed through the hole bezel area and around the optical hole.

According to embodiments of the present disclosure, among the gate lines, specific scan lines that significantly affect pixel luminance, are configured to be connected by bypass connection lines through the display area around the optical hole and the bypass connection lines are arranged to be vertically symmetrical with respect to the center line of the optical hole, thereby preventing differences in parasitic capacitance between the specific scan lines above and below the center line even if alignment is offset.

Consequently, no difference in kickback voltage arises between these scan lines, improving luminance uniformity in the display area around the optical hole.

According to embodiments of the present disclosure, since image quality defects due to luminance differences are reduced, the production energy required for additional manufacturing of the display devices can be reduced, and thus greenhouse gas emissions can also be reduced.

The effects of the present disclosure are not limited to those mentioned above, and other effects not explicitly described herein will be clearly understood by those skilled in the art from the descriptions in the claims.

### BRIEF DESCRIPTION OF THE DRAWINGS

FIG. 1 is a block diagram schematically illustrating an organic light-emitting display device according to one or more embodiments of the present disclosure.
FIG. 2 is a diagram illustrating the configuration of a gate driver in a display device according to one or more embodiments of the present disclosure.
FIG. 3 is an equivalent circuit diagram illustrating a pixel circuit of a pixel in a display device according to one or more embodiments of the present disclosure.
FIG. 4 is a plan view schematically illustrating a display device according to one or more embodiments of the present disclosure.
FIG. 5 is a cross-sectional view schematically illustrating a pixel of a display device according to one or more embodiments of the present disclosure.
FIG. 6 is a plan view illustrating a VI region of FIG. 4 and some of signal lines around an optical hole.
FIGS. 7 and 8 illustrate other signal lines around the optical hole according to one or more embodiments of the present disclosure.
FIG. 9 is a cross-sectional view taken along line IX-IX' of FIG. 6.
FIG. 10 illustrates some of signal lines around an optical hole according to one or more embodiments of the present disclosure.
FIG. 11 is a cross-sectional view of an A1 region of FIG. 10.
FIG. 12 is a cross-sectional view of an A2 region of FIG. 10.
FIG. 13 illustrates parasitic capacitance between a first scan line and a data line around an optical hole according to one or more embodiments of the present disclosure.
FIG. 14 illustrates some of signal lines around an optical hole in a comparative example.
FIG. 15 is a cross-sectional view taken along line XV-XV' of FIG. 14.
FIG. 16 illustrates parasitic capacitance between a first scan line and a data line in the comparative example.
FIG. 17 illustrates luminance differences in the display area around an optical hole in the comparative example.

### DETAILED DESCRIPTION

Advantages and features disclosed in the present disclosure and methods of accomplishing the same may be understood more readily by reference to the detailed description of embodiments that will be made hereinafter with reference to the accompanying drawings. The present disclosure is not limited to the embodiments described herein but may be embodied in various forms, and the embodiments are provided to ensure a complete disclosure of the invention and to fully convey the scope of the invention to those skilled in the art in the relevant technical field.

The shapes, sizes, ratios, angles, numbers and the like illustrated in the drawings to describe embodiments of the present disclosure are merely exemplary, and thus, the present disclosure is not limited thereto. Throughout the present disclosure, the same reference numerals refer to the same components. In addition, detailed descriptions of well-known technologies may be omitted in the present disclosure to avoid obscuring the subject matter of the present disclosure. When terms such as "comprises," "has," or "is made up of" are used in the present disclosure, it should be understood that unless "only" is specifically used, additional elements or steps can be included. Unless otherwise explicitly stated, when a component is expressed in the singular form, it is intended to encompass the plural form as well.

In interpreting the components, it is construed to include a margin of error even in the absence of explicit description.

In the case of describing the positional relationship between two parts, such as "on," "above," "below," "beside," or "adjacent," it should be understood that one or more other parts may be positioned between the two parts unless terms such as "directly," "immediately," or "closely" are used.

In the case of describing the temporal relationship between events, such as "after," "followed by," "next," or "before," it should be understood that non-continuous events may also be included unless terms like "immediately" or "directly" are used.

Terms like "first," "second," etc., are used to describe various components, but these components are not limited by these terms. These terms are merely used for distinguishing one component from the other components. Therefore, the first component mentioned hereinafter may be the second component in the technical sense of the present disclosure.

In describing the components of the present disclosure, terms such as "first," "second," "A," "B," "(a)," or "(b)" may be used. These terms are only used only to distinguish one component from another, and the nature, sequence, order, or quantity of the corresponding components are not limited by the term.

When it is stated that a component is "connected," "coupled," "linked," or "attached" to another component, it should be understood that the component may be directly connected, coupled, linked, or attached to the other component, but in the absence of explicit description, it may also be indirectly connected, coupled, linked, or attached through other components.

When it is stated that a component or layer is in "contact" or "overlapping" with another component or layer, it should be understood that the component or layer may be in direct contact or overlap with the other component or layer, but in the absence of explicit description, it may also be in indirect contact or overlap, with other components intervening between the components.

When a component is described as "at least one" it should be understood that all possible combinations of one or more of the related components are encompassed. For example, "at least one of the first, second, and third components" means not only the first, second, or third components individually but also any combination of two or more components out of the first, second, and third components.

The terms "first direction," "second direction," "third direction," "X-axis direction," "Y-axis direction," and "Z-axis direction" should not be interpreted solely based on their geometric relationship, which may be vertical, but rather within the functional scope of the configuration of the present disclosure, which may indicate broader directional meanings.

The various features of the embodiments of the disclosure can combined or assembled together, either partially or entirely, in a technically diverse manner, and each embodiment can be independently implemented or in conjunction with related embodiments.

Various embodiments of the present disclosure will now be described in detail with reference to the accompanying drawings.

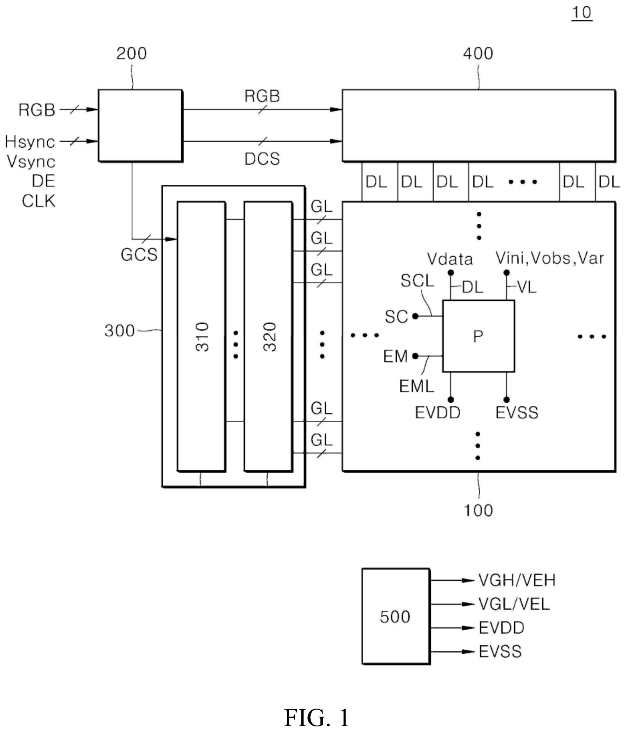

FIG. 1 is a block diagram schematically illustrating an organic light-emitting display device according to one or more embodiments of the present disclosure.

Referring to FIG. 1, the display device 10 includes a display panel 100 with a plurality of pixels P, a controller 200, a gate driver 300 that supplies gate signals to each of the plurality of pixels P, a data driver 400 that supplies data signals to each of the plurality of pixels P, and a power supply 500 that supplies the necessary driving power to each of the plurality of pixels P.

The display panel 100 includes a display area where the pixels P are located and a non-display area arranged to surround the display area. The non-display area may house the gate driver 300.

In the display panel 100, a plurality of gate lines GL and a plurality of data lines DL intersect with each other, and each of the plurality of pixels P is connected to the gate lines GL and data lines DL. Specifically, one pixel P receives a gate signal from the gate driver 300 via a gate line GL, a data signal from the data driver 400 via a data line DL, and a high-potential driving voltage EVDD and a low-potential driving voltage EVSS from the power supply 500.

Here, the gate line GL supplies a scan signal SC and a light emission control signal EM, while the data line DL supplies a data voltage Vdata. According to various embodiments, the gate line GL may include a plurality of scan lines SCL that supply the scan signal SC and a light emission control line EML that supplies the light emission control signal EM. The gate line GL may include the first to the fourth scan lines SCL1, SCL2, SCL3, and SCL4, and the light emission control line EML. Additionally, each of the plurality of pixels P may receive the bias voltage Vobs and the initialization voltage Var, Vini through the power line VL.

In addition, each pixel P includes a light-emitting element and a pixel circuit that controls the driving of the light-emitting element.

The pixel circuit includes a plurality of switching elements, driving elements, and capacitors. Here, the switching elements and driving element may be composed of thin-film transistors. In the pixel circuit, the driving element controls the current supplied to the light-emitting element based on the data voltage, thereby adjusting the light emission amount of the light-emitting element. Additionally, the plurality of switching elements receive a scan signal SC supplied via the plurality of scan lines SCL and an emission control signal EM supplied via the emission control line EML to operate the pixel circuit.

The display panel 100 may be implemented as a non-transmissive display panel or a transmissive display panel. A transmissive display panel may be applied to a transparent display device where an image is displayed on the screen and real objects in the background are visible.

The display panel 100 may be fabricated as a flexible display panel. The flexible display panel may be implemented as an organic light-emitting display panel using a plastic substrate.

Each pixel P may be divided into a red pixel, a green pixel, and a blue pixel for color reproduction. Each pixel P may further include a white pixel.

Touch sensors may be disposed on the display panel 100. Touch input may be sensed using separate touch sensors or through the pixels P. The touch sensors may be implemented as on-cell type or add-on type touch sensors disposed on the screen of the display panel, or as in-cell type touch sensors embedded in the display panel 100.

The controller 200 processes image data RGB input from an external host system to match the size and resolution of the display panel 100, and supplies the processed data to the data driver 400. The controller 200 generates a gate control signal GCS and a data control signal DCS using synchronization signals input from an external source, such as a dot clock signal CLK, a data enable signal DE, a horizontal synchronization signal Hsync, and a vertical synchronization signal Vsync. The controller 200 supplies the generated gate control signal GCS and data control signal DCS to the gate driver 300 and the data driver 400, respectively, thereby controlling the gate driver 300 and the data driver 400.

The controller 200 may be combined with various processors, such as a microprocessor, a mobile processor, or an application processor, depending on the device in which it is implemented.

The external host system may be, for example, any one of a TV system, a set-top box, a navigation system, a personal computer PC, a home theater system, a mobile device, a wearable device, or a vehicle system.

Based on timing signals Vsync, Hsync, and DE received from the external host system, the controller 200 generates a gate control signal GCS to control the operation timing of the gate driver 300 and a data control signal DCS to control the operation timing of the data driver 400. The controller 200 controls the operation timing of the display panel driving unit to synchronize the gate driver 300 and the data driver 400.

The voltage level of the gate control signal GCS output from the controller 200 may be converted into a gate-on voltage VGL, VEL and a gate-off voltage VGH, VEH through a level shifter (not shown) and supplied to the gate driver 300. The level shifter converts a low-level voltage of the gate control signal GCS into a gate low voltage VGL and a high-level voltage of the gate control signal GCS into a gate high voltage VGH. The gate control signal GCS includes a start pulse and a shift clock.

The gate driver 300 supplies scan signals SC to the gate line GL in response to the gate control signal GCS supplied from the controller 200. The gate driver 300 may be disposed on one side or both sides of the display panel 100 using a Gate In Panel GIP configuration.

The gate driver 300 sequentially outputs gate signals to the plurality of gate lines GL under the control of the controller 200. The gate driver 300 may sequentially supply the gate signals to the gate lines GL by shifting the gate signals using a shift register.

The gate signal may include a scan signal SC and an emission control signal EM in an organic light-emitting display device. The scan signal SC includes a scan pulse that swings between a gate-on voltage VGL and a gate-off voltage VGH. The emission control signal EM may include an emission control signal pulse that swings between a gate-on voltage VEL and a gate-off voltage VEH.

The scan pulse selects the pixels P of the line into which the data voltage Vdata is to be written, synchronized with the data voltage. The light emission control signal EM defines the light emission time of the pixels P.

The gate driver 300 may include a light emission control signal driver 310 and at least one scan driver 320.

The emission control signal driver 310 outputs an emission control signal pulse in response to a start pulse and a shift clock from the controller 200 and sequentially shifts the emission control signal pulse according to the shift clock.

The at least one scan driver 320 outputs a scan pulse in response to a start pulse and a shift clock from the controller 200, and shifts the scan pulse in accordance with the shift clock timing.

The data driver 400 converts image data RGB into a data voltage Vdata in response to the data control signal DCS supplied from the controller 200 and supplies the converted data voltage Vdata to the pixels P through the data line DL.

In FIG. 1, the data driver 400 is illustrated as being disposed on one side of the display panel 100 in a single form, but the number and arrangement position of the data driver 400 are not limited thereto.

That is, the data driver 400 may be configured with a plurality of integrated circuits IC and may be separately arranged in plurality on one side of the display panel 100.

The power supply 500 generates direct current DC power required to drive the pixel array and the display panel driving unit of the display panel 100 using a DC-DC converter. The DC-DC converter may include a charge pump, a regulator, a buck converter, a boost converter, and the like. The power supply 500 may receive a direct current input voltage from a host system (not shown) and generate direct current voltages such as a gate-on voltage VGL and VEL, a gate-off voltage VGH/VEH, a high-potential driving voltage EVDD, and a low-potential driving voltage EVSS. The gate-on voltage VGL, VEL and the gate-off voltage VGH, VEH are supplied to the gate driver 300 through a level shifter (not shown). The high-potential driving voltage EVDD and the low-potential driving voltage EVSS are commonly supplied to the pixels P.

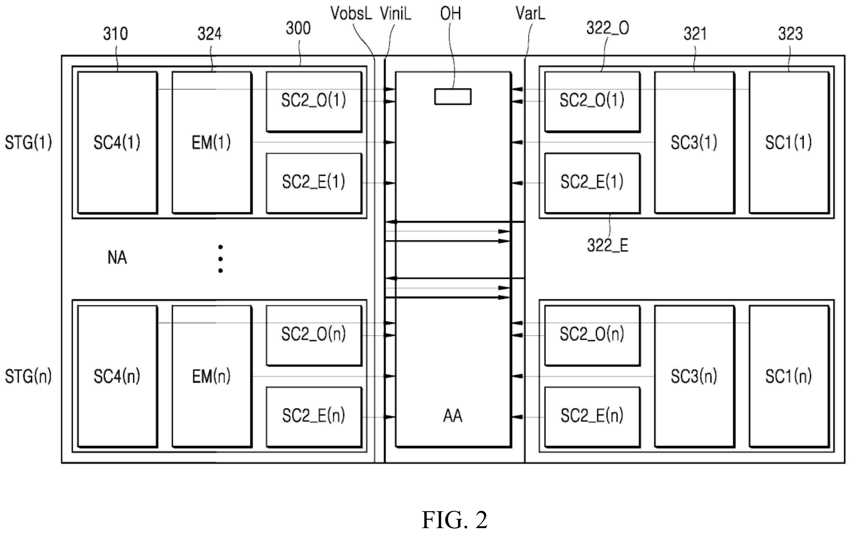

FIG. 2 is a diagram illustrating the configuration of a gate driver in a display device according to one or more embodiments of the present disclosure.

Referring to FIG. 2, the gate driver 300 includes a light emission control signal driver 310 and a scan driver 320. The scan driver 320 may include a first scan driver to a fourth scan driver 321, 322, 323, and 324. In addition, the second scan driver 322 may be composed of an odd-numbered second scan driver 322_O and an even-numbered second scan driver 322_E.

The gate driver 300 may include shift registers symmetrically configured on both sides of the display area AA. Also, the gate driver 300 may be configured such that the shift register on one side of the display area AA includes the second scan drivers 322_O and 322_E, the fourth scan driver 324, and the light emission control signal driver 310, and the shift register on the other side of the display area AA includes the first scan driver 321, the second scan drivers 322_O and 322_E, and the third scan driver 323. However, this is not limited thereto, and the light emission control signal driver 310 and the first to fourth scan drivers 321, 322, 323, and 324 may be arranged differently depending on the embodiment.

Each stage STG1 to STGn of the shift register may include first scan signal generators SC1(1) to SC1(n), second scan signal generators SC2_O(1) to SC2_O(n) and SC2_E(1) to SC2_E(n), third scan signal generators SC3(1) to SC3(n), fourth scan signal generators SC4(1) to SC4(n), and light emission control signal generators EM(1) to EM(n).

The first scan signal generators SC1(1) to SC1(n) output first scan signals SC1(1) to SC1(n) through first scan lines SCL1 of the display panel 100. The second scan signal generators SC2(1) to SC2(n) output second scan signals SC2(1) to SC2(n) through second scan lines SCL2 of the display panel 100. The third scan signal generators SC3(1) to SC3(n) output third scan signals SC3(1) to SC3(n) through third scan lines SCL3 of the display panel 100. The fourth scan signal generators SC4(1) to SC4(n) output fourth scan signals SC4(1) to SC4(n) through fourth scan lines SCL4 of the display panel 100. The light emission control signal generators EM(1) to EM(n) output light emission control signals EM(1) to EM(n) through light emission control lines EML of the display panel 100.

The first scan signals SC1(1) to SC1(n) may be used as signals for driving A transistors (e.g., compensation transistors, etc.) included in the pixel circuit. The second scan signals SC2(1) to SC2(n) may be used as signals for driving B transistors (e.g., data supply transistors, etc.) included in the pixel circuit. The third scan signals SC3(1) to SC3(n) may be used as signals for driving C transistors (e.g., bias transistors, etc.) included in the pixel circuit. The fourth scan signals SC4(1) to SC4(n) may be used as signals for driving D transistors (e.g., initialization transistors, etc.) included in the pixel circuit. The light emission control signals EM(1) to EM(n) may be used as signals for driving E transistors (e.g., light emission control transistors, etc.) included in the pixel circuit. For example, by using the light emission control signals EM(1) to EM(n) to control the light emission control transistors of the pixels, the light emission time of the light-emitting element may be varied.

The odd-numbered second scan driver 322_O may be connected to the second scan lines of the odd-numbered pixel rows and may apply a driving signal thereto, and the even-numbered second scan driver 322_E may be connected to the second scan lines of the even-numbered pixel rows and may apply a driving signal thereto. The odd-numbered second scan driver 322_O may be disposed on both sides of the display area AA and may operate in a dual feeding manner that applies driving signals in both directions for each of the odd-numbered pixel rows. The even-numbered second scan driver 322_E may be disposed on both sides of the display area AA and may operate in a dual feeding manner that applies driving signals in both directions for each of the even-numbered pixel rows.

Referring to FIG. 2, a bias voltage bus line VobsL, a first initialization voltage bus line VarL, and a second initialization voltage bus line ViniL may be disposed between the gate driver 300 and the display area AA.

The bias voltage bus line VobsL, the first initialization voltage bus line VarL, and the second initialization voltage bus line ViniL may respectively supply a bias voltage Vobs, a first initialization voltage Var, and a second initialization voltage Vini from the power supply 500 to the pixel circuit.

In the drawings, the bias voltage bus line VobsL, the first initialization voltage bus line VarL, and the second initialization voltage bus line ViniL are illustrated as being located only on either the left or the right side of the display area AA, but are not limited thereto and may also be disposed on both sides.

Referring to FIG. 2, one or more optical holes OH may be disposed in the display area AA.

The one or more optical holes OH may be disposed to overlap with one or more optical electronic devices such as an imaging device (e.g., camera or image sensor), a proximity sensor, and an ambient light sensor. The one or more optical holes OH may have a light transmittance above a certain threshold to allow the operation of the optical electronic devices.

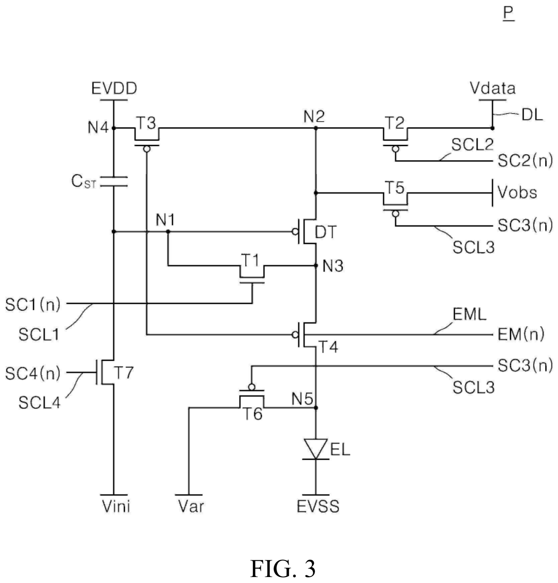

FIG. 3 is an equivalent circuit diagram illustrating a pixel circuit of a pixel in a display device according to one or more embodiments of the present disclosure.

FIG. 3 merely illustrates one example of a pixel circuit. The pixel circuit is not limited as long as it has a structure capable of controlling light emission of a light-emitting element (EL). For example, the pixel circuit may include additional scan signals and switching thin-film transistors connected thereto, and switching thin-film transistors to which additional initialization voltages are applied, and the connection relationships of switching elements and the arrangement positions of capacitors may also vary.

Referring to FIG. 3, each of a plurality of pixels P may include a pixel circuit having a driving transistor DT and a light-emitting element EL connected to the pixel circuit.

The pixel circuit may drive the light-emitting element EL by controlling a driving current flowing through the light-emitting element EL. The pixel circuit may include the driving transistor DT, first to seventh transistors T1 to T7, and a capacitor Cst. The transistors DT and T1 to T7 may each include a first electrode, a second electrode, and a gate electrode. One of the first and second electrodes may be a source electrode, and the other may be a drain electrode.

Each of the transistors DT and T1 to T7 may be a P-type thin-film transistor or an N-type thin-film transistor. In the embodiment of FIG. 3, the first transistor T1 and the seventh transistor T7 are configured as N-type thin-film transistors, while the remaining transistors DT and T2 to T6 are configured as P-type thin-film transistors. However, the present disclosure is not limited thereto, and all or some of the transistors DT and T1 to T7 may be P-type thin-film transistors or N-type thin-film transistors, depending on the embodiment. In addition, the N-type thin-film transistor may be an oxide thin-film transistor, and the P-type thin-film transistor may be a polycrystalline silicon thin-film transistor.

Hereinafter, the first transistor T1 and the seventh transistor T7 will be described by way of example as N-type thin-film transistors, and the remaining transistors DT and T2 to T6 will be described as P-type thin-film transistors. Accordingly, the first transistor T1 and the seventh transistor T7 are turned on when a high voltage is applied, and the remaining transistors DT and T2 to T6 are turned on when a low voltage is applied.

According to one example, in the pixel circuit, the first transistor T1 may function as a compensation transistor, the second transistor T2 as a data supply transistor, the third and fourth transistors T3 and T4 as emission control transistors, the fifth transistor T5 as a bias transistor, and the sixth and seventh transistors T6 and T7 as initialization transistors.

The emissive component EL may include an anode electrode and a cathode electrode. The anode electrode of the emissive component EL may be connected to the fifth node N5, and the cathode electrode may be connected to a low-potential driving voltage EVSS.

The driving transistor DT may include a first electrode connected to the second node N2, a second electrode connected to the third node N3, and a gate electrode connected to the first node N1. The driving transistor DT may supply a driving current to the light-emitting element EL based on the voltage of a first node N1 (or a data voltage stored in a capacitor Cst, as described later).

The first transistor T1 may include a first electrode connected to the first node N1, a second electrode connected to a third node N3, and a gate electrode configured to receive a first scan signal SC1(n) through a first scan line SCL1. The first transistor T1 may be turned on in response to the first scan signal SC1(n), and may sample the threshold voltage Vth of the driving transistor DT by being connected between the first node N1 and the third node N3. Such a first transistor T1 may serve as a compensation transistor.

The capacitor Cst may be connected or formed between the first node N1 and a fourth node N4. The capacitor Cst may store or maintain the high-potential driving voltage EVDD that is supplied.

The second transistor T2 may include a first electrode connected to a data line DL for receiving a data voltage Vdata, a second electrode connected to a second node N2, and a gate electrode configured to receive a second scan signal SC2(n) through a second scan line SCL2. The second transistor T2 may be turned on in response to the second scan signal SC2(n) and may transfer the data voltage Vdata to the second node N2. Such a second transistor T2 may serve as a data supply transistor.

The third transistor T3 and fourth transistor T4 (or the first and second emissive control transistors) may be connected between the high-potential driving voltage EVDD and the emissive component EL to form a current path for the driving current generated by the driving transistor DT.

The third transistor T3 may include a first electrode connected to the fourth node N4 for receiving the high-potential driving voltage EVDD, a second electrode connected to the second node N2, and a gate electrode configured to receive a light emission control signal EM(n) through the light emission control line EML.

The fourth transistor T4 may include a first electrode connected to the third node N3, a second electrode connected to the fifth node N5 (or the anode electrode of the light-emitting element EL), and a gate electrode configured to receive a light emission control signal EM(n) through the light emission control line EML.

In response to the light emission control signal EM(n), the third and fourth transistors T3 and T4 may be turned on, supplying the driving current to the light-emitting element EL, which then emits light with a luminance corresponding to the driving current Id.

The fifth transistor T5 may include a first electrode receiving the bias voltage Vobs, a second electrode connected to the second node N2, and a gate electrode configured to receive the third scan signal SC3(n) through the third scan line SCL3. This fifth transistor T5 may function as a bias transistor.

The sixth transistor T6 may include a first electrode receiving the first initialization voltage Var, a second electrode connected to the fifth node N5, and a gate electrode configured to receive the third scan signal SC3(n) through the third scan line SCL3.

The sixth transistor T6 may be turned on in response to the third scan signal SC3(n) either before or after the light-emitting element EL emits light, and may use the first initialization voltage Var to initialize the anode electrode (or pixel electrode) of the light-emitting element EL. The light-emitting element EL may have a parasitic capacitor formed between its anode and cathode electrodes. During the light emission of the light-emitting element EL, the parasitic capacitor may be charged, causing the anode electrode of the light-emitting element EL to reach a specific voltage. Therefore, by applying the first initialization voltage Var to the anode electrode of the light-emitting element EL through the sixth transistor T6, the accumulated charge in the light-emitting element EL can be reset.

In the present disclosure, the gate electrodes of the fifth and sixth transistors T5 and T6 are configured to receive the third scan signal SC3 in common. However, this is not necessarily limited, and the gate electrodes of the fifth and sixth transistors T5 and T6 may receive separate scan signals and be configured to be controlled independently.

The seventh transistor T7 may include a first electrode receiving the second initialization voltage Vini, a second electrode connected to the first node N1, and a gate electrode configured to receive the fourth scan signal SC4 through the fourth scan line SCL4.

In response to the fourth scan signal SC4, the seventh transistor T7 may be turned on and use the second initialization voltage Vini to reset the gate electrode of the driving transistor DT. The gate electrode of the driving transistor DT may retain unnecessary charge due to the high-voltage driving voltage EVDD stored in the capacitor Cst. Therefore, by applying the second initialization voltage Vini to the gate electrode of the driving transistor DT through the seventh transistor T7, the residual charge can be reset.

In the pixel circuit illustrated in FIG. 3, the luminance of the pixel's light-emitting element is determined by the voltage charged to the first node N1. The transistors directly connected to the first node N1 are the first transistor T1 and the seventh transistor T7. The signal that turns the first transistor T1 on and off is the first scan signal SC1(n), and the signal that turns the seventh transistor T7 on and off is the fourth scan signal SC4(n). Therefore, if the parasitic capacitance of the first scan line SCL1 and the fourth scan line SCL4 changes, the voltage at the first node N1 will change. As a result, the variation in the parasitic capacitance of the first scan line SCL1 and the fourth scan line SCL4 will more sensitively affect the luminance of the pixel's light-emitting element compared to the other scan lines (SCL2, SCL3) and the emission control line EML.

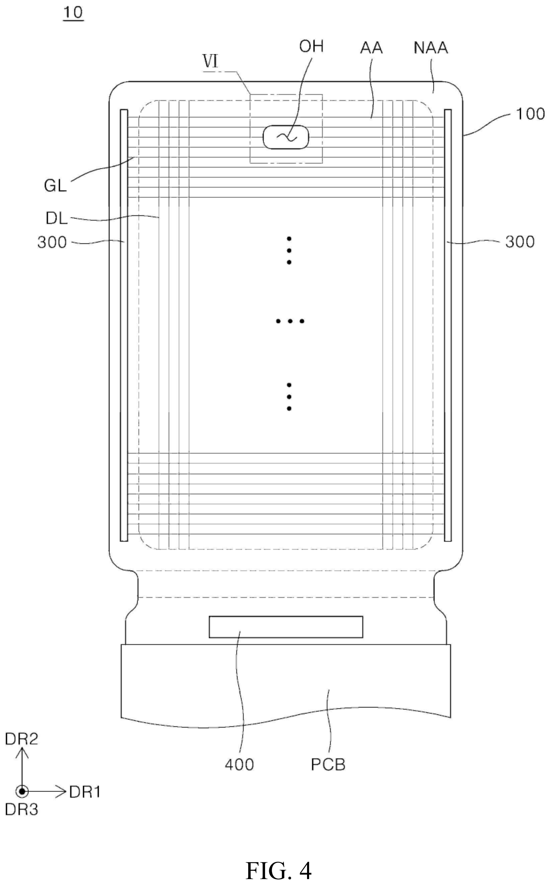

FIG. 4 is a plan view schematically illustrating a display device according to one or more embodiments of the present disclosure.

Referring to FIG. 4, a display device 10 according to one or more embodiments of the present disclosure may include a display panel 100, a data driver 400, a printed circuit board PCB, and so on.

The display panel 100 includes a display area AA and a non-display area NAA. The display area AA and non-display area NAA may be regions of the substrate of the display panel 100. The display area AA is the region where images are displayed. The non-display area NAA is the region outside the display area AA where images are not displayed.

The display area AA is the region where a plurality of pixels are arranged. The non-display area NAA is the region where a gate driver 300 and various wiring components are arranged.

The display area AA includes a plurality of data lines DL and a plurality of gate lines GL that are arranged to intersect each other. The plurality of gate lines GL may extend in a first direction DR1, for example, and the plurality of data lines DL may extend in a second direction DR2, for example. The plurality of gate lines GL may include first to fourth scan lines SCL1, SCL2, SCL3, and SCL4 that supply scan signals, and a light emission control line EML that supplies light emission control signals.

The display panel 100 may include an optical hole OH located in the display area AA. The optical hole OH may penetrate through the display panel 100. The optical hole OH may be surrounded by the display area AA. The optical hole OH may be a camera hole. A plurality of data lines DL and a plurality of gate lines GL may be configured to bypass the optical hole OH.

The non-display area NAA may be arranged to surround the display area AA. The non-display area NAA may be located at the upper, lower, left, and right sides of the display area AA. The gate driver 300 may be positioned in the non-display area NAA located at the left and right sides of the display area AA, for example. The gate driver 300 may be directly formed on the substrate of the display panel 100 in a gate driver in panel (GIP) configuration.

The non-display area NAA located at the lower side of the display area AA may have the data driver 400 and the printed circuit board PCB attached thereto. The controller 200, power supply 500, and the like may be mounted on the printed circuit board PCB.

A portion of the non-display area NAA located at the lower side of the display panel 100 may be bent with a predetermined curvature. As a result, the data driver 400 and printed circuit board PCB may be positioned beneath the display panel 100. This can reduce the lower bezel area of the display device 10, as perceived from the front of the display device.

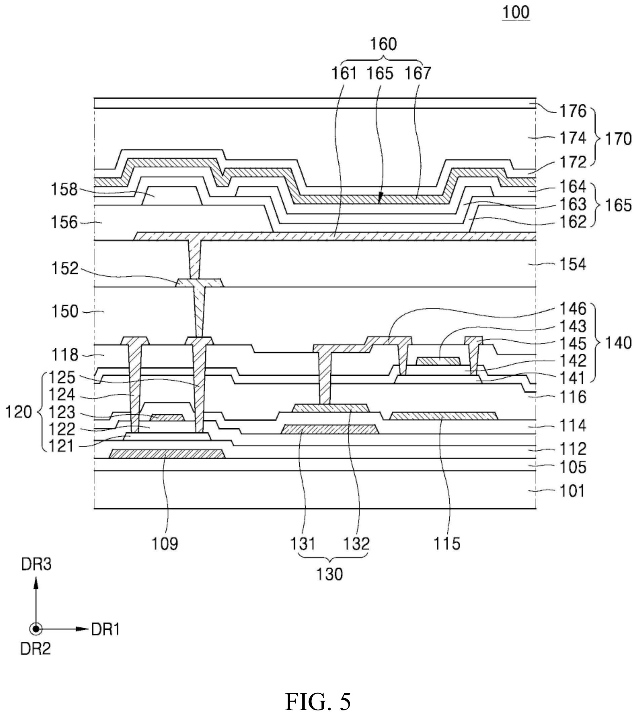

FIG. 5 is a cross-sectional view schematically illustrating a pixel of a display device according to one or more embodiments of the present disclosure.

Referring to FIG. 5, the display panel 100 of the display device according to one or more embodiments of the present disclosure may include a substrate 101, a first thin-film transistor 120, a storage capacitor 130, a second thin-film transistor 140, a light-emitting element 160, and a touch sensor 186.

The substrate 101 may include an insulating material. The substrate 101 may be made of a polymer material having flexibility. The substrate 101 may have a multi-layer structure. For example, the substrate 101 may include a lower substrate layer and an upper substrate layer made of a polymer material, such as polyimide (PI), and an intermediate layer made of an inorganic insulating material disposed between the lower and upper substrate layers.

A first buffer layer 105 may be disposed on the substrate 101. The first buffer layer 105 may be disposed over the entire display area AA of the substrate 101. The first buffer layer 105 may include an insulating material. For example, the first buffer layer 105 may include inorganic insulating materials such as silicon oxide, silicon nitride, or silicon oxynitride. The first buffer layer 105 may have a multi-layer structure.

A first light-shielding layer 109 may be disposed over the first buffer layer 105. The first light-shielding layer 109 may include a metal material. For example, the first light-shielding layer 109 may include metal materials such as aluminum (Al), chromium (Cr), copper (Cu), titanium (Ti), molybdenum (Mo), or tungsten (W).

A second buffer layer 112 may be disposed over the first light-shielding layer 109, covering it, and positioned on the first buffer layer 105. The second buffer layer 112 may include an insulating material. For example, the second buffer layer 112 may include inorganic insulating materials such as silicon oxide, silicon nitride, or silicon oxynitride. The second buffer layer 112 may have a multi-layer structure.

A pixel circuit may be disposed in each subpixel. For example, the pixel circuit may include a first thin-film transistor 120, a second thin-film transistor 140, and a storage capacitor 130.

The first thin-film transistor 120 may be electrically connected to the light-emitting element 160. The first thin-film transistor 120 may include a first semiconductor pattern 121, a first gate insulating layer 122, a first gate electrode 123, a first source electrode 124, and a first drain electrode 125. The first thin-film transistor 120 may be a P-type thin-film transistor. The first thin-film transistor 120 may be a polycrystalline silicon thin-film transistor. The first thin-film transistor 120 may be a driving transistor.

The first semiconductor pattern 121 may be disposed on the second buffer layer 112, overlapping with the first light-shielding layer 109. Light passing through the substrate 101 towards the first semiconductor pattern 121 may be blocked by the first light-shielding layer 109. Therefore, the characteristics of the first thin-film transistor 120 can be protected from changes caused by external light.

The first semiconductor pattern 121 may include a semiconductor material. For example, the first semiconductor pattern 121 may include a polycrystalline semiconductor material. For example, the first semiconductor pattern 121 may include low-temperature polycrystalline silicon (LTPS).

The first gate insulating layer 122 may be located on the first semiconductor pattern 121. The first gate insulating layer 122 may extend outward from the first semiconductor pattern 121. For example, the first gate insulating layer 122 may extend along the upper surface of the second buffer layer 112. The first gate insulating layer 122 may include an insulating material. For example, the first gate insulating layer 122 may include inorganic insulating materials such as silicon oxide, silicon nitride, and silicon oxynitride.

The first gate electrode 123 may be positioned on the first gate insulating layer 122. The first gate electrode 123 may overlap with the first semiconductor pattern 121. The first gate electrode 123 may include a conductive material. For example, the first gate electrode 123 may include metal materials such as aluminum (Al), chromium (Cr), copper (Cu), titanium (Ti), molybdenum (Mo), and tungsten (W). The first gate electrode 123 may be electrically insulated from the first semiconductor pattern 121 by the first gate insulating layer 122. The first gate electrode 123 may be electrically connected to the first light-shielding layer 109.

The first interlayer insulating layer 114 may be located on the first gate electrode 123. The first interlayer insulating layer 114 may extend outward from the first gate electrode 123. The first interlayer insulating layer 114 may extend along the upper surface of the first gate insulating layer 122. The first interlayer insulating layer 114 may include an insulating material. For example, the first interlayer insulating layer 114 may include inorganic insulating materials such as silicon oxide, silicon nitride, and silicon oxynitride.

The first source electrode 124 and the first drain electrode 125 may be electrically connected to the first semiconductor pattern 121.

The storage capacitor 130 may include a first storage electrode 131 and a second storage electrode 132. For example, the first storage electrode 131 may be positioned in the same layer as the first gate electrode 123. The first storage electrode 131 may be formed of the same material as the first gate electrode 123. The first storage electrode 131 may be disposed on the first gate insulating layer 122 near the first gate electrode 123. The second storage electrode 132 may be disposed on the first interlayer insulating layer 114 to overlap with the first storage electrode 131.

The first storage electrode 131 and the second storage electrode 132 may include a conductive material. For example, the first storage electrode 131 and the second storage electrode 132 may include metal materials such as aluminum (Al), chromium (Cr), copper (Cu), titanium (Ti), molybdenum (Mo), and tungsten (W).

A second light-shielding layer 115 may be disposed on the first interlayer insulating layer 114. The second light-shielding layer 115 may be positioned in the same layer as the second storage electrode 132. The second light-shielding layer 115 may be formed of the same material as the second storage electrode 132.

A separation insulating layer 116 may be disposed on the first interlayer insulating layer 114 to cover the second storage electrode 132 and the second light-shielding layer 115. The separation insulating layer 116 may include an insulating material. For example, the separation insulating layer 116 may include inorganic insulating materials such as silicon oxide, silicon nitride, and silicon oxynitride. The separation insulating layer 116 may have a multilayer structure including silicon oxide and silicon nitride.

The second thin-film transistor 140 may be electrically connected to the first thin-film transistor 120. For example, the second thin-film transistor 140 may include a second semiconductor pattern 141, a second gate insulating layer 142, a second gate electrode 143, a second source electrode 145, and a second drain electrode 146. The second thin-film transistor 140 may be an n-type thin-film transistor. The second thin-film transistor 140 may be an oxide thin-film transistor. The second thin-film transistor 140 may be a switching transistor.

The second semiconductor pattern 141 may be located in a different layer from the first semiconductor pattern 121. The second semiconductor pattern 141 may be disposed on the separation insulating layer 116 so as to overlap with the second light-shielding layer 115. Light passing through the substrate 101 toward the second semiconductor pattern 141 may be blocked by the second light-shielding layer 115. Accordingly, changes in the characteristics of the second thin-film transistor 140 caused by external light may be prevented.

The second semiconductor pattern 141 may include a semiconductor material. The second semiconductor pattern 141 may include a material different from that of the first semiconductor pattern 121. For example, the second semiconductor pattern 141 may include an oxide semiconductor such as IGZO.

The second gate insulating layer 142 may be disposed on the second semiconductor pattern 141. The second gate insulating layer 142 may extend outward of the second semiconductor pattern 141. For example, the second gate insulating layer 142 may extend along the top surface of the separation insulating layer 116. The second gate insulating layer 142 may include an insulating material. The second gate insulating layer 142 may include inorganic insulating materials such as silicon oxide, silicon nitride, and silicon oxynitride.

The second gate electrode 143 may be disposed on the second gate insulating layer 142. The second gate electrode 143 may overlap the second semiconductor pattern 141. The second gate electrode 143 may include a conductive material. For example, the second gate electrode 143 may include a metal material such as aluminum (Al), chromium (Cr), copper (Cu), titanium (Ti), molybdenum (Mo), or tungsten (W). For example, the second gate electrode 143 may be formed of the same material as the first gate electrode 123. The second gate electrode 143 may be electrically insulated from the second semiconductor pattern 141 by the second gate insulating layer 142. The second gate electrode 143 may be electrically connected to the second light-shielding layer 115.

A second interlayer insulating layer 118 may be disposed on the second gate electrode 143. The second interlayer insulating layer 118 may extend beyond the outer side of the second gate electrode 143. The second interlayer insulating layer 118 may extend along the upper surface of the separation insulating layer 116. The second interlayer insulating layer 118 may include an insulating material. For example, the second interlayer insulating layer 118 may include inorganic insulating materials such as silicon oxide, silicon nitride, and silicon oxynitride. The second interlayer insulating layer 118 may have a multilayer structure including silicon oxide and silicon nitride.

The first source electrode 124, the first drain electrode 125, the second source electrode 145, and the second drain electrode 146 may be disposed on the second interlayer insulating layer 118. The first source electrode 124, the first drain electrode 125, the second source electrode 145, and the second drain electrode 146 may include a conductive material. For example, the first source electrode 124, the first drain electrode 125, the second source electrode 145, and the second drain electrode 146 may include metal materials such as aluminum (Al), chromium (Cr), copper (Cu), titanium (Ti), molybdenum (Mo), and tungsten (W). The first source electrode 124, the first drain electrode 125, the second source electrode 145, and the second drain electrode 146 may have a multilayer structure of titanium (Ti)/aluminum (Al)/titanium (Ti).

The first source electrode 124 and the first drain electrode 125 may be electrically connected to the first semiconductor pattern 121. For example, the first source electrode 124 and the first drain electrode 125 may be in direct contact with the first semiconductor pattern 121 through contact holes penetrating the second interlayer insulating layer 118, the second gate insulating layer 142, the separation insulating layer 116, the first interlayer insulating layer 114, and the first gate insulating layer 122.

The second source electrode 145 and the second drain electrode 146 may be electrically connected to the second semiconductor pattern 141. For example, the second source electrode 145 and the second drain electrode 146 may be in direct contact with the second semiconductor pattern 141 through contact holes penetrating the second interlayer insulating layer 118 and the second gate insulating layer 142.

The storage capacitor 130 may be electrically connected to the second drain electrode 146 of the second thin-film transistor 140. For example, the second drain electrode 146 may be in contact with the second storage electrode 132 through a contact hole penetrating the second interlayer insulating layer 118, the second gate insulating layer 142, and the separation insulating layer 116.

The light-emitting element 160 may be disposed on the pixel circuit. For example, the first thin-film transistor 120, the second thin-film transistor 140, and the storage capacitor 130 of each sub-pixel may be positioned between the substrate 101 and the light-emitting element 160.

A first planarization layer 150 and a second planarization layer 154 may be sequentially stacked between the pixel circuit and the light-emitting element 160. The first planarization layer 150 and the second planarization layer 154 may cover surface irregularities caused by the pixel circuit and provide a planar surface. For example, the first planarization layer 150 and the second planarization layer 154 may include an organic insulating material.

A pixel contact electrode 152 may be disposed on the first planarization layer 150. The light-emitting element 160 may be disposed on the second planarization layer 154. The light-emitting element 160 may include a first electrode 161, a light-emitting layer 165, and a second electrode 167. The light-emitting element 160 may be electrically connected to the first drain electrode 125 of the first thin-film transistor 120 through the pixel contact electrode 152. The pixel contact electrode 152 may include a conductive material. For example, the pixel contact electrode 152 may include a metal material such as aluminum (Al), chromium (Cr), copper (Cu), titanium (Ti), molybdenum (Mo), or tungsten (W). For example, the pixel contact electrode 152 may have a multilayer structure of titanium (Ti)/aluminum (Al)/titanium (Ti).

A bank layer 156 may be disposed on the second planarization layer 154. The bank layer 156 may include an organic insulating material. For example, the bank layer 156 may be formed of a photosensitive acrylic-based or polyimide-based organic material.

The bank layer 156 may cover the edge of the first electrode 161. The bank layer 156 may have an opening that exposes a portion of the first electrode 161.

An emission region may be defined by the portion of the first electrode 161 exposed through the opening of the bank layer 156. The first electrode 161 may include a conductive material. The first electrode 161 may have a high reflectance. For example, the first electrode 161 may include a metal material such as aluminum (Al) or silver (Ag). The first electrode 161 may have a multilayer structure. For example, the first electrode 161 may have a structure in which a metal such as aluminum (Al) or silver (Ag) is disposed between transparent conductive materials such as ITO and IZO.

The light-emitting layer 165 and the second electrode 167 of the light-emitting element 160 may be stacked on the first electrode 161 and the bank layer 156.

The light-emitting layer 165 may include an emission material layer 163. For example, the emission material layer 163 may include an organic light-emitting material. The light-emitting layer 165 may have a multilayer structure. For example, the light-emitting layer 165 may include at least one of a first light-emitting common layer 162 located between the first electrode 161 and the emission material layer 163, and a second light-emitting common layer 164 located between the emission material layer 163 and the second electrode 167. For example, the first light-emitting common layer 162 may include at least one of a hole injection layer (HIL) and a hole transport layer (HTL). The second light-emitting common layer 164 may include at least one of an electron transport layer (ETL) and an electron injection layer (EIL).

For example, when the sub-pixels of each pixel are designed to emit light of different colors, the emission material layers 163 of the respective sub-pixels may be separated from those of adjacent sub-pixels. The emission material layer 163 of each sub-pixel may be separately formed using a fine metal mask (FMM). An end of the emission material layer 163 may be located on the bank layer 156.

For example, a spacer 158 may be disposed on the bank layer 156. The spacer 158 may prevent damage to the bank layer 156 and the emission material layer 163 caused by contact with the fine metal mask. For example, the spacer 158 may be formed of a photosensitive acrylic-based or polyimide-based organic material. The bank layer 156 and the spacer 158 may be simultaneously formed by a single photolithography process, but are not limited thereto. The bank layer 156 and the spacer 158 may be separately formed through different processes.

The first light-emitting common layer 162 and the second light-emitting common layer 164 of the light-emitting layer 165 may extend along the surface of the bank layer 156. The first light-emitting common layer 162 and the second light-emitting common layer 164 of the light-emitting layer 165 may cover the top surface and side surfaces of the spacer 158. For example, the first light-emitting common layer 162 and the second light-emitting common layer 164 may be commonly disposed across adjacent sub-pixels. For example, each of the first light-emitting common layer 162 and the second light-emitting common layer 164 may be commonly disposed for all the pixels in the display area AA.

The second electrode 167 may be commonly disposed on adjacent sub-pixels. For example, the second electrode 167 may be commonly disposed on all pixels of the display area AA. The second electrode 167 may include a conductive material. For example, the second electrode 167 may be a transparent electrode made of transparent conductive materials such as ITO and IZO.

An encapsulation layer 170 may be disposed on the light-emitting element 160. The encapsulation layer 170 may prevent damage to the light-emitting elements 160 from external impacts and moisture. The encapsulation layer 170 may have a multi-layer structure. For example, the encapsulation layer 170 may include a first encapsulation layer 172, a second encapsulation layer 174, and a third encapsulation layer 176 stacked in sequence. For example, the first encapsulation layer 172 and the third encapsulation layer 176 may include inorganic insulating materials, and the second encapsulation layer 174 may include an organic insulating material.

The encapsulation layer 170 may extend to the non-display area NAA as well as the display area AA.

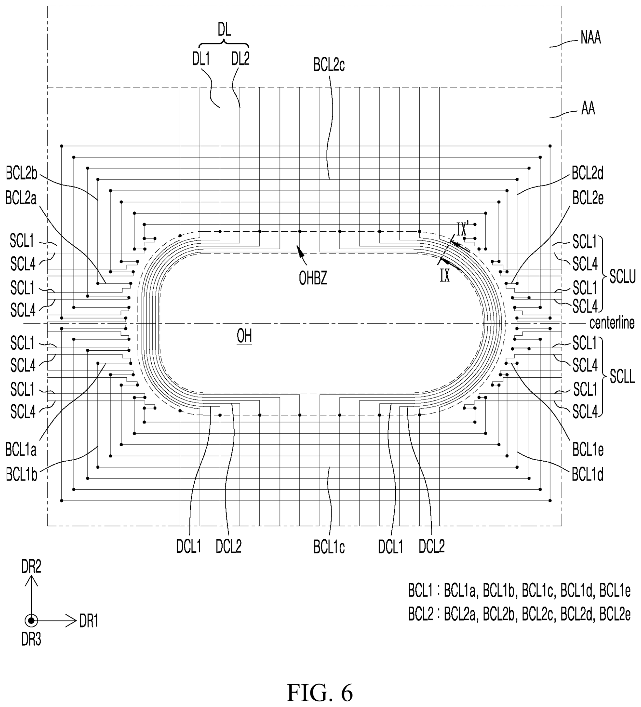

FIG. 6 is a plan view illustrating a VI region of FIG. 4 and some of signal lines around an optical hole. In FIG. 6, for convenience of explanation, the first scan line SCL1, the fourth scan line SCL4, the data line DL, the lower bypass connection line BCL1, and the upper bypass connection line BCL2 are shown.

Referring to FIG. 6, an optical hole OH may be provided in the display area AA of the display panel 100. Around the optical hole OH, a ring-shaped hole bezel area OHBZ may be provided. In the hole bezel area OHBZ, various signal wirings bypassing the optical hole OH may be arranged.

In the display area AA, a plurality of data lines DL may extend in the second direction DR2. Although only the plurality of data lines DL arranged at the upper and lower sides of the optical hole OH in the display area AA are shown in the drawing, a plurality of data lines DL are also arranged at the left and right sides of the optical hole OH in the display area AA. Hereinafter, a plurality of data lines DL arranged at the upper and lower sides of the optical hole OH will be described.

The plurality of data lines DL may bypass the optical hole OH through the hole bezel area OHBZ.

The plurality of data lines DL may include a first data line DL1 and a second data line DL2, alternately arranged in the first direction DR1.

The first data line DL1 may include a first portion arranged at the upper side of the optical hole OH, a second portion arranged at the lower side of the optical hole OH, and a first data connection line DCL1 connecting the first and second portions, which is arranged in the hole bezel area OHBZ. The first and second portions of the first data line DL1 may be arranged in the same layer. The first data connection line DCL1 of the first data line DL1 may be arranged in a layer below the first and second portions of the first data line DL1. The first and second portions of the first data line DL1 may be arranged in the same layer with the pixel contact electrode 152 made of the same material. The first data connection line DCL1 of the first data line DL1 may be arranged in the same layer and made of the same material as the second source electrode 145 and the second drain electrode 146.

The second data line DL2 may include a first portion arranged at the upper side of the optical hole OH, a second portion arranged at the lower side of the optical hole OH, and a second data connection line DCL2 connecting the first and second portions, which is arranged in the hole bezel area OHBZ. The first portion, second portion, and second data connection line DCL2 of the second data line DL2 may be arranged in the same layer as the first and second portions of the first data line DL1. The second data connection line DCL2 may be arranged in a layer above the first data connection line DCL1. The first portion, second portion, and second data connection line DCL2 of the second data line DL2 may be arranged in the same layer with the pixel contact electrode 152 made of the same material.

In the display area AA, a plurality of first scan lines SCL1 and a plurality of fourth scan lines SCL4 may extend in the first direction DR1. Although only a plurality of first scan lines SCL1 and a plurality of fourth scan lines SCL4 arranged in the display area AA on the left and right sides of the optical hole OH are shown in the drawing, a plurality of first scan lines SCL1 and a plurality of fourth scan lines SCL4 may also be arranged in the display area AA on the upper and lower sides of the optical hole OH. The first scan lines SCL1 and the fourth scan lines SCL4 may be alternately arranged in the second direction DR2. Hereinafter, a description will be given of the plurality of first scan lines SCL1 and the plurality of fourth scan lines SCL4 arranged on the left and right sides of the optical hole OH.

The plurality of first scan lines SCL1 and the plurality of fourth scan lines SCL4 may be disconnected by the optical hole OH. Each of the first scan lines SCL1 may include a first portion disposed on one side or the left side of the optical hole OH and a second portion disposed on the other side or the right side of the optical hole OH. The first portion and the second portion of each first scan line SCL1 may be spaced apart from each other by the optical hole OH. Each of the fourth scan lines SCL4 may include a first portion disposed on one side or the left side of the optical hole OH and a second portion disposed on the other side or the right side of the optical hole OH. The first portion and the second portion of each fourth scan line SCL4 may be spaced apart from each other by the optical hole OH.

An end of the first portion of each first scan line SCL1 may be located within the display area AA on one side or the left side of the optical hole OH. An end of the second portion of each first scan line SCL1 may be located within the display area AA on the other side or the right side of the optical hole OH. An end of the first portion of each fourth scan line SCL4 may be located within the display area AA on one side or the left side of the optical hole OH. An end of the second portion of each fourth scan line SCL4 may be located within the display area AA on the other side or the right side of the optical hole OH.

The first and second portions of the first scan line SCL1 or the fourth scan line SCL4, which are disposed below the center line of the optical hole OH, may be connected by a lower bypass connection line BCL1 disposed in the display area AA. The lower bypass connection line BCL1 may include a first lower connection portion BCL1a connected to the first portion of the first scan line SCL1 or the fourth scan line SCL4, a second lower connection portion BCL1b connected to the first lower connection portion BCL1a, a BCL1c connected to the second lower connection portion BCL1b, a fourth lower connection portion BCL1d connected to the third lower connection portion BCL1c, and a fifth lower connection portion BCL1e connected to the fourth lower connection portion BCL1d and to the second portion of the first scan line SCL1 or the fourth scan line SCL4. The center line of the optical hole OH may be a line extending in the first direction DR1 and passing through the center of the optical hole OH. The first and fourth scan lines disposed below the center line of the optical hole OH may be lower scan lines SCLL.

The first lower connection portion BCL1a may extend in the display area AA, for example, in the first direction DR1 away from the optical hole OH. The first lower connection portion BCL1a may extend in the display area AA in a direction parallel to the extension direction of the first scan line SCL1 and the fourth scan line SCL4. The first lower connection portion BCL1a may extend in the display area AA in a direction intersecting the direction in which the plurality of data lines DL extend.

The second lower connection portion BCL1b may extend in the display area AA in a second direction DR2 intersecting the first direction DR1. The second lower connection portion BCL1b may extend in the display area AA in a direction intersecting the extension direction of the first scan line SCL1 and the fourth scan line SCL4.

The third lower connection portion BCL1c may extend in the display area AA in the first direction DR1. The third lower connection portion BCL1c may extend in the display area AA in a direction parallel to the extension direction of the first scan line SCL1 and the fourth scan line SCL4. The third lower connection portion BCL1c may extend in the display area AA in a direction intersecting the direction in which the plurality of data lines DL extend.

The fourth lower connection portion BCL1d may extend in the display area AA in the second direction DR2 intersecting the first direction DR1. The fourth lower connection portion BCL1d may extend in the display area AA in a direction intersecting the extension direction of the first scan line SCL1 and the fourth scan line SCL4.

The fifth lower connection portion BCL1e may extend in the display area AA, for example, in the first direction DR1 toward the optical hole OH. The fifth lower connection portion BCL1e may extend in the display area AA in a direction parallel to the extension direction of the first scan line SCL1 and the fourth scan line SCL4. The fifth lower connection portion BCL1e may extend in the display area AA in a direction intersecting the direction in which the plurality of data lines DL extend.

The lower bypass connection line BCL1 may be disposed in a different layer from the first scan line SCL1 and the fourth scan line SCL4. The lower bypass connection line BCL1 may be disposed in an upper layer relative to the first scan line SCL1 and the fourth scan line SCL4.

The first lower connection portion BCL1a, the third lower connection portion BCL1c, and the fifth lower connection portion BCL1e may be disposed in the same layer and may be disposed in an upper layer relative to the first scan line SCL1 and the fourth scan line SCL4. The first lower connection portion BCL1a and the fifth lower connection portion BCL1e may be connected to the first scan line SCL1 and the fourth scan line SCL4 through an insulating layer.

The second lower connection portion BCL1b and the fourth lower connection portion BCL1d may be disposed in the same layer and may be disposed in an upper layer relative to the first lower connection portion BCL1a, the third lower connection portion BCL1c, and the fifth lower connection portion BCL1e. The second lower connection portion BCL1b may be connected to the first lower connection portion BCL1a and the third lower connection portion BCL1c through an insulating layer. The fourth lower connection portion BCL1d may be connected to the third lower connection portion BCL1c and the fifth lower connection portion BCL1e through an insulating layer.

The first portion and the second portion of the first scan line SCL1 or the fourth scan line SCL4, which are disposed above the center line of the optical hole OH, may be connected by an upper bypass connection line BCL2 disposed within the display area AA. The upper bypass connection line BCL2 may include a first upper connection portion BCL2a connected to the first portion of the first scan line SCL1 or the fourth scan line SCL4, a second upper connection portion BCL2b connected to the first upper connection portion BCL2a, a third upper connection portion BCL2c connected to the second upper connection portion BCL2b, a fourth upper connection portion BCL2d connected to the third upper connection portion BCL2c, and a fifth upper connection portion BCL2e connected to the fourth upper connection portion BCL2d and to the second portion of the first scan line SCL1 or the fourth scan line SCL4. The first and fourth scan lines disposed above the center line of the optical hole OH may be upper scan lines SCLU.

The first upper connection portion BCL2a may extend, for example, in the display area AA in a direction away from the optical hole OH along the first direction DR1. The first upper connection portion BCL2a may extend in the display area AA in a direction parallel to the extending direction of the first scan line SCL1 and the fourth scan line SCL4. The first upper connection portion BCL2a may extend in the display area AA in a direction intersecting the extending direction of the plurality of data lines DL.

The second upper connection portion BCL2b may extend in the display area AA in a second direction DR2 intersecting the first direction DR1. The second upper connection portion BCL2b may extend in the display area AA in a direction intersecting the extending direction of the first scan line SCL1 and the fourth scan line SCL4.

The third upper connection portion BCL2c may extend in the display area AA along the first direction DR1. The third upper connection portion BCL2c may extend in the display area AA in a direction parallel to the extending direction of the first scan line SCL1 and the fourth scan line SCL4. The third upper connection portion BCL2c may extend in the display area AA in a direction intersecting the extending direction of the plurality of data lines DL.

The fourth upper connection portion BCL2d may extend in the display area AA in the second direction DR2 intersecting the first direction DR1. The fourth upper connection portion BCL2d may extend in the display area AA in a direction intersecting the extending direction of the first scan line SCL1 and the fourth scan line SCL4.

The fifth upper connection portion BCL2e may extend, for example, in the display area AA in a direction approaching the optical hole OH along the first direction DR1. The fifth upper connection portion BCL2e may extend in the display area AA in a direction parallel to the extending direction of the first scan line SCL1 and the fourth scan line SCL4. The fifth upper connection portion BCL2e may extend in the display area AA in a direction intersecting the extending direction of the plurality of data lines DL.

The upper bypass connection line BCL2 may be disposed on a different layer from the first scan line SCL1 and the fourth scan line SCL4. The upper bypass connection line BCL2 may be disposed on a layer above the first scan line SCL1 and the fourth scan line SCL4.

The first upper connection portion BCL2a, the third upper connection portion BCL2c, and the fifth upper connection portion BCL2e may be disposed on the same layer and may be disposed on a layer above the first scan line SCL1 and the fourth scan line SCL4. The first upper connection portion BCL2a and the fifth upper connection portion BCL2e may be connected to the first scan line SCL1 and the fourth scan line SCL4 through an insulating layer.

The second upper connection portion BCL2b and the fourth upper connection portion BCL2d may be disposed on the same layer and may be disposed on a layer above the first upper connection portion BCL2a, the third upper connection portion BCL2c, and the fifth upper connection portion BCL2e. The second upper connection portion BCL2b may be connected to the first upper connection portion BCL2a and the third upper connection portion BCL2c through an insulating layer. The fourth upper connection portion BCL2d may be connected to the third upper connection portion BCL2c and the fifth upper connection portion BCL2e through an insulating layer.

As shown in FIG. 6, the lower bypass connection line BCL1 and the upper bypass connection line BCL2 may be disposed symmetrically with respect to the center line of the optical hole OH.

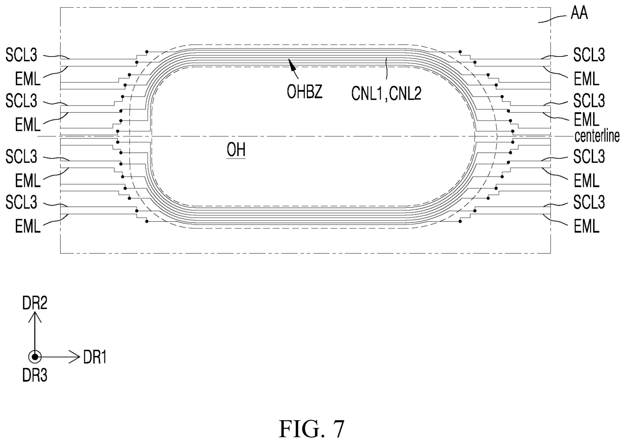

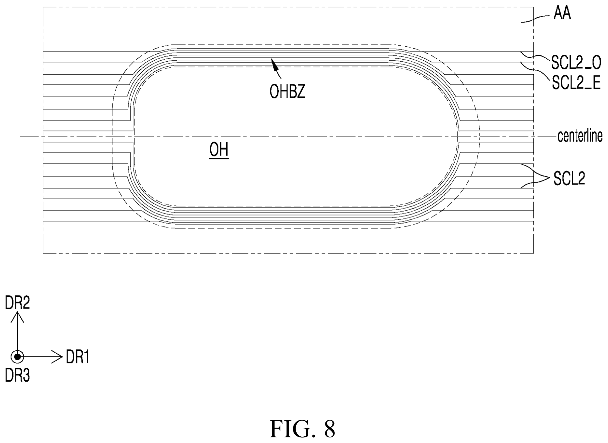

FIGS. 7 and 8 illustrate other signal lines around the optical hole.

Referring to FIG. 7, a plurality of third scan lines SCL3 and a plurality of emission control lines EML may extend in the first direction DR1 within the display area AA. Although the drawing illustrates only the plurality of third scan lines SCL3 and the plurality of emission control lines EML arranged in the display area AA on the left and right sides of the optical hole OH, the plurality of third scan lines SCL3 and the plurality of emission control lines EML are also arranged in the display area AA on the lower and upper sides of the optical hole OH. The third scan lines SCL3 and the emission control lines EML may be alternately arranged in the second direction DR2. Hereinafter, a description will be given of the plurality of third scan lines SCL3 and the plurality of emission control lines EML arranged on the left and right sides of the optical hole OH.

The plurality of third scan lines SCL3 and the plurality of emission control lines EML may be disconnected by the optical hole OH. Each of the third scan lines SCL3 may include a first portion disposed on one side or the left side of the optical hole OH and a second portion disposed on the other side or the right side of the optical hole OH. The first portion and the second portion of each third scan line SCL3 may be spaced apart from each other by the optical hole OH. Each of the emission control lines EML may include a first portion disposed on one side or the left side of the optical hole OH and a second portion disposed on the other side or the right side of the optical hole OH. The first portion and the second portion of each emission control line EML may be spaced apart from each other by the optical hole OH.

An end of the first portion of each third scan line SCL3 may be located within the display area AA on one side or the left side of the optical hole OH. An end of the second portion of each third scan line SCL3 may be located within the display area AA on the other side or the right side of the optical hole OH. An end of the first portion of each emission control line EML may be located within the display area AA on one side or the left side of the optical hole OH. An end of the second portion of each emission control line EML may be located within the display area AA on the other side or the right side of the optical hole OH.

The first portion and the second portion of each third scan line SCL3 may be connected by a first connection line CNL1 disposed in the hole bezel region OHBZ. The first portion and the second portion of each emission control line EML may be connected by a second connection line CNL2 disposed in the hole bezel region OHBZ. The first connection line CNL1 and the second connection line CNL2 may be alternately arranged in the second direction DR2.

The plurality of third scan lines SCL3 and the plurality of emission control lines EML may be disposed on the same layer. The plurality of third scan lines SCL3 and the plurality of emission control lines EML may be disposed on the same layer as the first gate electrode 123.

The first and second connection lines CNL1 and CNL2 may be disposed on a layer above the plurality of third scan lines SCL3 and the plurality of emission control lines EML. The first and second connection lines CNL1 and CNL2 may be disposed on the same layer as the second light-shielding layer 115 or the second storage electrode 132.

Referring to FIG. 8, the plurality of second scan lines SCL2 in the display area AA may extend in the first direction DR1. The plurality of second scan lines SCL2 may bypass the optical hole OH and pass through the hole bezel area OHBZ. The plurality of second scan lines SCL2 may be disposed in the display area AA on the left and right sides of the optical hole OH and in the hole bezel area OHBZ. The plurality of second scan lines SCL2 may include a plurality of odd-numbered second scan lines SCL2_O and a plurality of even-numbered second scan lines SCL2_E. In the drawing, only the plurality of second scan lines SCL2 that bypass the optical hole OH and pass through the hole bezel area OHBZ are illustrated, but a plurality of second scan lines SCL2 are also disposed in the display area AA above and below the optical hole OH. The plurality of second scan lines SCL2 may be disposed on the same layer as the first gate electrode 123.

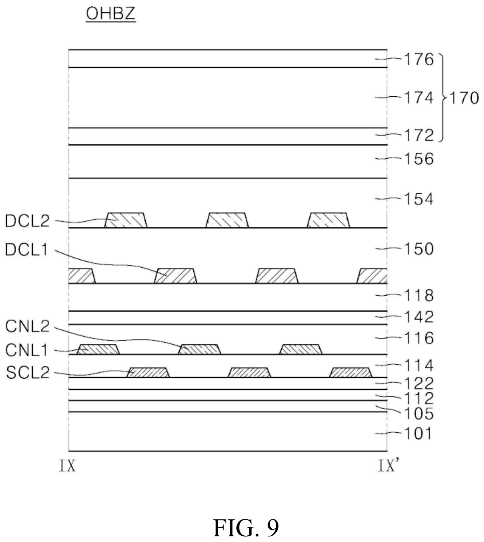

FIG. 9 is a cross-sectional view taken along line IX-IX' of FIG. 6.

Referring to FIG. 9, a first buffer layer 105, a second buffer layer 112, and a first gate insulating layer 122 may be sequentially disposed on the substrate 101.

A plurality of second scan lines SCL2 may be disposed on the first gate insulating layer 122. The plurality of second scan lines SCL2 may be disposed on the same layer and formed of the same material as the first gate electrode 123. An interlayer insulating layer 114 may be disposed over the plurality of second scan lines SCL2.

A plurality of first connection lines CNL1 and a plurality of second connection lines CNL2 may be disposed on the interlayer insulating layer 114. A separation insulating layer 116 may be disposed over the plurality of first connection lines CNL1 and the plurality of second connection lines CNL2.

A second gate insulating layer 142 and a second interlayer insulating layer 118 may be sequentially stacked on the separation insulating layer 116.

A plurality of first data connection lines DCL1 may be disposed on the second interlayer insulating layer 118. The plurality of first data connection lines DCL1 may be disposed on the same layer and formed of the same material as the second source electrode 145 and the second drain electrode 146. A first planarization layer 150 may be disposed on the plurality of first data connection lines DCL1.

A plurality of second data connection lines DCL2 may be disposed on the first planarization layer 150. The plurality of second data connection lines DCL2 may be disposed on the same layer and formed of the same material as the pixel contact electrode 152. A second planarization layer 154 may be disposed on the plurality of second data connection lines DCL2.

A bank layer 156 and an encapsulation layer 170 may be disposed on the second planarization layer 154.

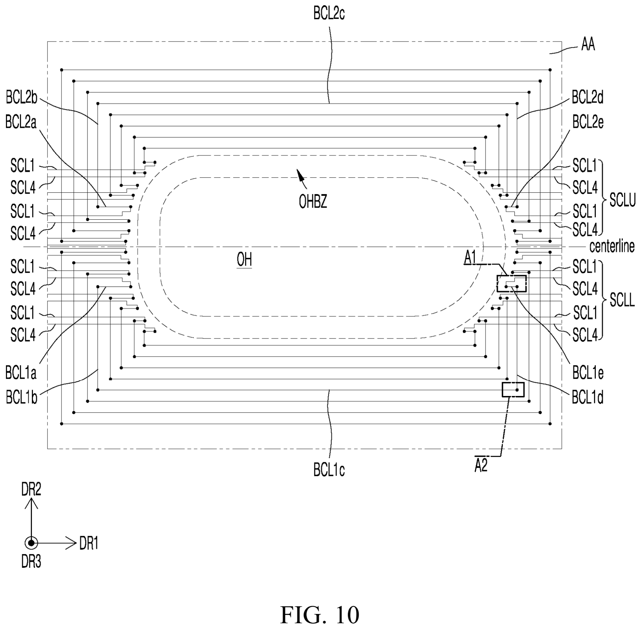

Referring to FIGS. 10 to 12, a connection structure of a lower bypass connection line will be described. The description of the connection structure of the lower bypass connection line may be identically or similarly applied to an upper bypass connection line.

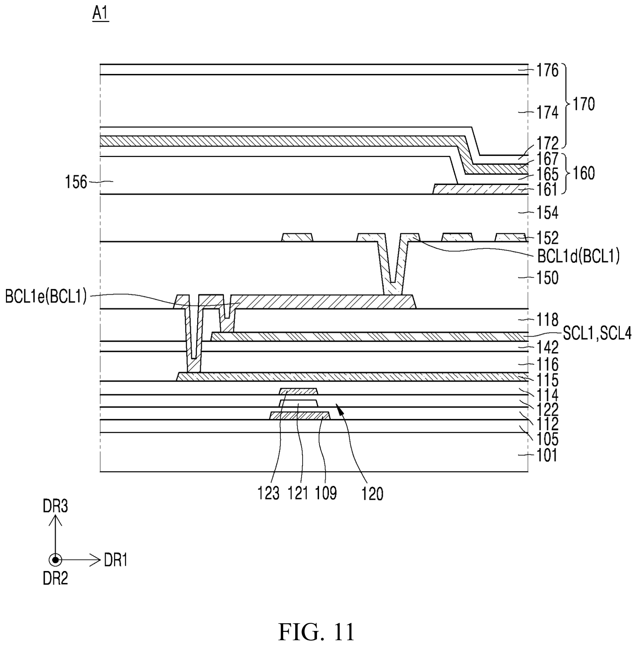

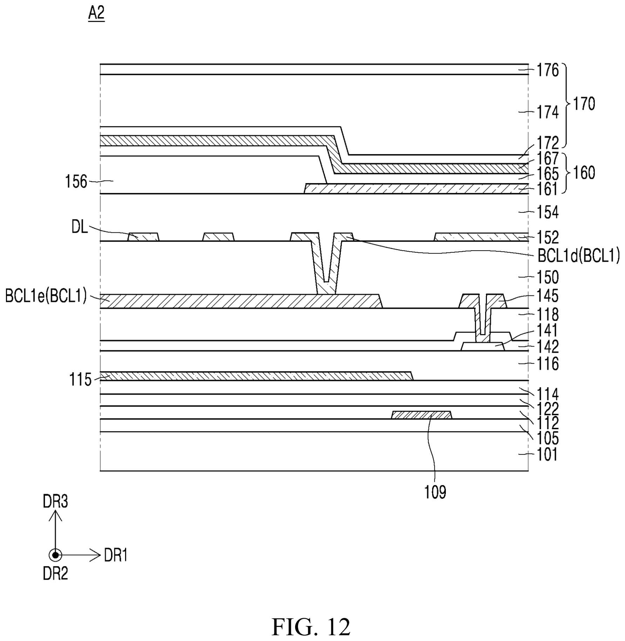

FIG. 10 illustrates some of signal lines around an optical hole according to one or more embodiments of the present disclosure. FIG. 11 is a cross-sectional view of an A1 region of FIG. 10. FIG. 12 is a cross-sectional view of an A2 region of FIG. 10.

Referring to FIGS. 10 and 11, a first buffer layer 105 may be disposed on the substrate 101, and a second buffer layer 112 may be disposed on the first buffer layer 105, covering the first light-shielding layer 109. A first semiconductor pattern 121 may be disposed on the second buffer layer 112, and a first gate insulating layer 122 may cover the first semiconductor pattern 121 while being disposed on the second buffer layer 112. A first gate electrode 123 may be disposed on the first gate insulating layer 122 to overlap the first semiconductor pattern 121.

A first interlayer insulating layer 114 may be disposed over the plurality of first gate electrodes 123. A second light-shielding layer 115 may be disposed on the first interlayer insulating layer 114. The second light-shielding layer 115 may extend in a first direction DR1.

A separation insulating layer 116 may be disposed on the second light-shielding layer 115. The separation insulating layer 116 may cover the second light-shielding layer 115 and be disposed on the first interlayer insulating layer 114.

A second gate insulating layer 142 may be disposed on the separation insulating layer 116. A fourth scan line SCL4 may be disposed on the second gate insulating layer 142. The fourth scan line SCL4 may extend in the first direction DR1. The fourth scan line SCL4 may overlap the second light-shielding layer 115. The fourth scan line SCL4 may be disposed in the same layer as and formed of the same material as the second gate electrode 143. Although not shown, a first scan line SCL1 may also be disposed next to the fourth scan line SCL4 on the second gate insulating layer 142. The first scan line SCL1 may extend in the first direction DR1. A second light-shielding layer 115 may also be disposed below the first scan line SCL1.

A second interlayer insulating layer 118 may be disposed on the second gate insulating layer 142 to cover the fourth scan line SCL4.

A fifth lower connection portion BCL1e of the lower bypass connection line BCL1 may be disposed on the second interlayer insulating layer 118. The fifth lower connection portion BCL1e may extend in the first direction DR1. To the right of the optical hole OH, a fifth lower connection portion BCL1e may be simultaneously connected to the fourth scan line SCL4 and the second light-shielding layer 115. The fifth lower connection portion BCL1e may pass through the second interlayer insulating layer 118 to connect to the fourth scan line SCL4, and may also pass through the second interlayer insulating layer 118, the second gate insulating layer 142, and the separation insulating layer 116 to connect to the second light-shielding layer 115. Accordingly, the same signal may be delivered to both the second light-shielding layer 115 and the fourth scan line SCL4, and the second light-shielding layer 115 may function as a back gate of thin-film transistors connected to the fourth scan line SCL4. The fifth lower connection portion BCL1e may be disposed in the same layer as and formed of the same material as the second source electrode 145 and the second drain electrode 146.

A first planarization layer 150 may be disposed on the fifth lower connection portion BCL1e of the lower bypass connection line BCL1. The first planarization layer 150 may cover the fifth lower connection portion BCL1e and be disposed on the second interlayer insulating layer 118.

A fourth lower connection portion BCL1d of the lower bypass connection line BCL1 may be disposed on the first planarization layer 150. The fourth lower connection portion BCL1d may extend in the second direction DR2. The fourth lower connection portion BCL1d may pass through the first planarization layer 150 to connect to the fifth lower connection portion BCL1e. The fourth lower connection portion BCL1d may be disposed in the same layer as and formed of the same material as the pixel contact electrode 152.

A second planarization layer 154 may be disposed on the fourth lower connection portion BCL1d. The second planarization layer 154 may cover the fourth lower connection portion BCL1d and be disposed on the first planarization layer 150.

A bank layer 156, a light-emitting element 160, and an encapsulation layer 170 may be disposed on the second planarization layer 154.

Referring to FIGS. 10 and 12, a third lower connection portion BCL1c of the lower bypass connection line BCL1 may be disposed on the second interlayer insulating layer 118. The third lower connection portion BCL1c may extend in the first direction DR1. The third lower connection portion BCL1c may be disposed in the same layer as and formed of the same material as the second source electrode 145 and the second drain electrode 146.

A fourth lower connection portion BCL1d may be disposed on the first planarization layer 150. The fourth lower connection portion BCL1d may extend in the second direction DR2. The fourth lower connection portion BCL1d may pass through the first planarization layer 150 to connect to the third lower connection portion BCL1c. The fourth lower connection portion BCL1d may be disposed in the same layer as and formed of the same material as the data line DL and the pixel contact electrode 152.

Similar to the description above, a first lower connection portion BCL1a of the lower bypass connection line BCL1 may be disposed on the second interlayer insulating layer 118. Similar to the fifth lower connection portion BCL1e, the first lower connection portion BCL1a may be simultaneously connected to the fourth scan line SCL4 and the second light-shielding layer 115 to the left of the optical hole OH.

A second lower connection portion BCL1b of the lower bypass connection line BCL1 may be disposed on the first planarization layer 150. The second lower connection portion BCL1b may pass through the first planarization layer 150 to connect to the first lower connection portion BCL1a. The second lower connection portion BCL1b may also pass through the first planarization layer 150 to connect to the third lower connection portion BCL1c. The second lower connection portion BCL1b may be disposed in the same layer as the data line DL.

In FIGS. 10 to 12, the connection structure between the fourth scan line SCL4 and the lower bypass connection line BCL1 may be identical or similar to the connection structure between the first scan line SCL1 and the lower bypass connection line BCL1.

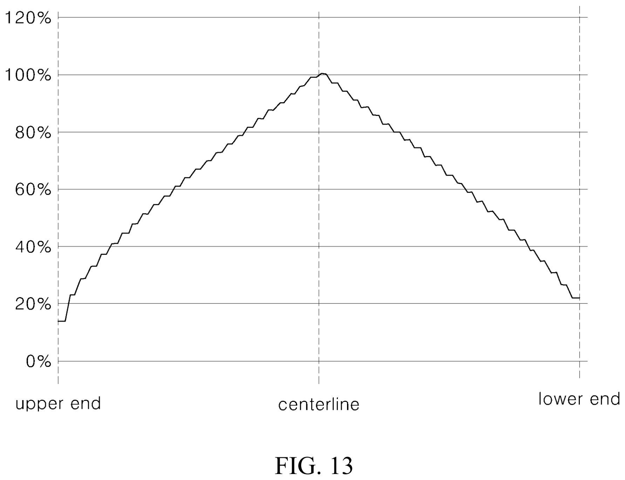

FIG. 13 illustrates parasitic capacitance between a first scan line and a data line around an optical hole according to one or more embodiments of the present disclosure.

Referring to FIG. 13, as in the embodiment of the present disclosure, since the first scan line SCL1 and the fourth scan line SCL4 among the gate lines GL, which significantly affect the luminance of the pixel, are bypass-connected through the display area AA around the optical hole OH, and the lower bypass connection line BCL1 and the upper bypass connection line BCL2 are symmetrically arranged with respect to the centerline of the optical hole OH, even when the alignment of the first scan line SCL1 and the fourth scan line SCL4 is offset, no difference may occur in the parasitic capacitance of the first and fourth scan lines disposed above and below the centerline of the optical hole.

Consequently, according to one or more embodiments of the present disclosure, no difference may occur in the kickback voltage of the first and fourth scan lines disposed above and below the centerline of the optical hole, and the luminance uniformity in the display area around the optical hole may be improved.

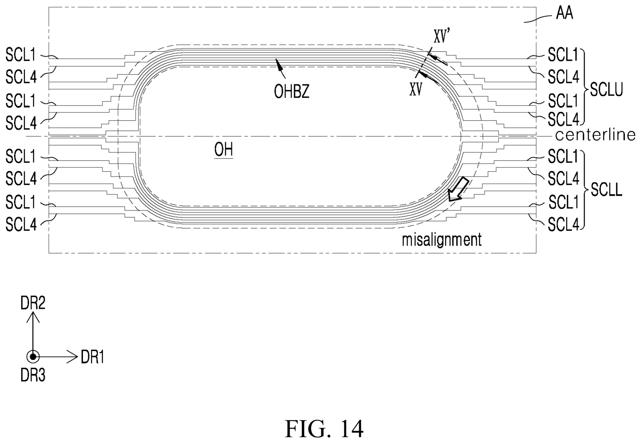

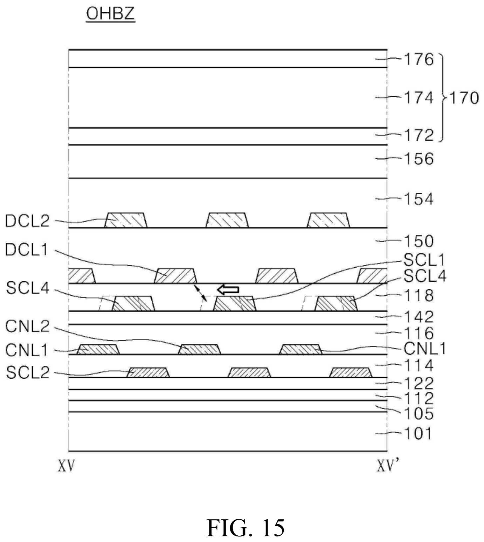

FIG. 14 illustrates some of signal lines around an optical hole in a comparative example. FIG. 15 is a cross-sectional view taken along line XV-XV' of FIG. 14.

Referring to FIG. 14, a plurality of first scan lines SCL1 and a plurality of fourth scan lines SCL4 bypass the optical hole OH through the hole bezel area OHBZ.

Referring to FIG. 15, unlike FIG. 9, the first scan line SCL1 and the fourth scan line SCL4 may be disposed between the second gate insulating layer 142 and the second interlayer insulating layer 118. When the alignment of the first scan line SCL1 and the fourth scan line SCL4 is offset, the parasitic capacitance between the first scan line SCL1 and the fourth scan line SCL4 and the first data connection line DCL1 may vary.

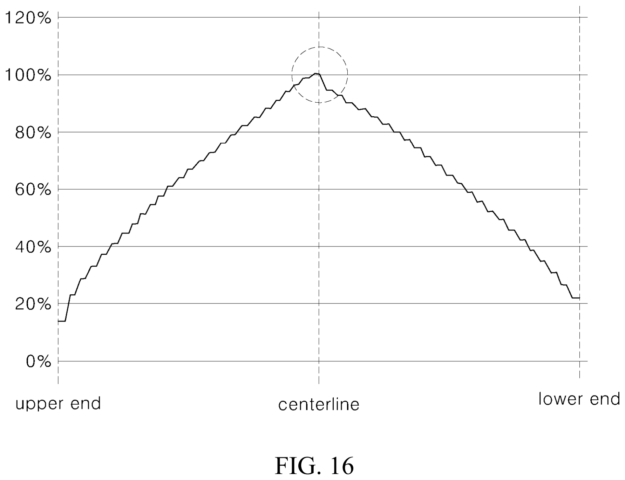

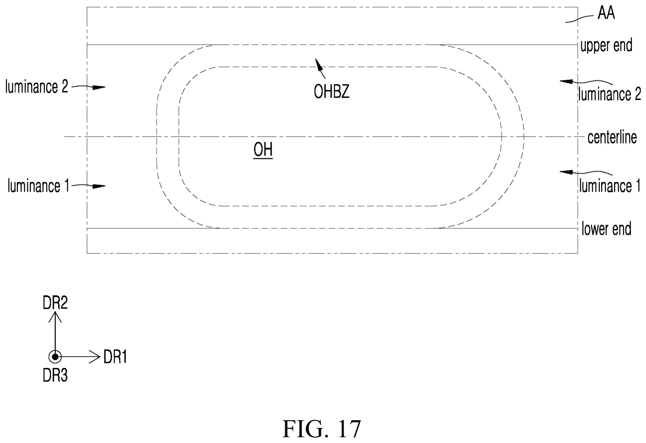

FIG. 16 illustrates parasitic capacitance between a first scan line and a data line in the comparative example. FIG. 17 illustrates luminance differences in the display area around an optical hole in the comparative example.

Referring to FIG. 16, when the alignment of the first scan line is offset, a step difference in parasitic capacitance occurs at the centerline position of the optical hole OH. Due to this difference in parasitic capacitance, the kickback voltage of the upper first scan line and the kickback voltage of the lower first scan line become different. As a result, a luminance difference occurs in the display area based on the centerline of the optical hole.

Referring to FIG. 17, when, as in FIG. 16, the parasitic capacitance of the lower first scan lines is lower than that of the upper first scan lines, the luminance of the display area located below the centerline of the optical hole may be greater than the luminance of the display area located above the centerline of the optical hole (Luminance 1 > Luminance 2).

The display device according to various embodiments of the present disclosure may be described as follows.

A display device according to embodiments of the present disclosure includes a display panel including a display area with a plurality of pixels, an optical hole within the display area, and a hole bezel area surrounding the optical hole, a plurality of scan lines extending in a first direction in the display area and disconnected by the optical hole, a plurality of bypass connection lines disposed in the display area, connecting disconnected portions of the plurality of scan lines, and a plurality of data lines extending in a second direction intersecting the first direction in the display area and passing through the hole bezel area.

According to some embodiments of the present disclosure, the plurality of bypass connection lines may include a plurality of lower bypass connection lines connecting disconnected portions of the plurality of scan lines disposed below a centerline of the optical hole, and a plurality of upper bypass connection lines connecting disconnected portions of the plurality of scan lines disposed above the centerline of the optical hole.

According to some embodiments of the present disclosure, the plurality of lower bypass connection lines and the plurality of upper bypass connection lines may be arranged symmetrically with respect to the centerline of the optical hole.

According to some embodiments of the present disclosure, each disconnected scan line may include a first portion disposed on one side of the optical hole and a second portion disposed on the other side of the optical hole. Each lower bypass connection line may include a first lower connection portion connected to the first portion of the respective scan line disposed below the centerline of the optical hole, a second lower connection portion connected to the first lower connection portion, a third lower connection portion connected to the second lower connection portion, a fourth lower connection portion connected to the third lower connection portion, and a fifth lower connection portion connected to the fourth lower connection portion and the second portion of the scan line.

According to some embodiments of the present disclosure, the first lower connection portion, the third lower connection portion, and the fifth lower connection portion may extend in the second direction, and the second lower connection portion and the fourth lower connection portion may extend in the first direction.

According to some embodiments of the present disclosure, the first lower connection portion, the third lower connection portion, and the fifth lower connection portion may be disposed on the same layer and above the layer of the respective scan lines. The second lower connection portion and the fourth lower connection portion may be disposed on the same layer and above the layer of the first lower connection portion, the third lower connection portion, and the fifth lower connection portion.

According to some embodiments of the present disclosure, the second lower connection portion and the fourth lower connection portion may be disposed on the same layer as the plurality of data lines in the display area.

According to some embodiments of the present disclosure, the first lower connection portion, the third lower connection portion, and the fifth lower connection portion may be disposed on the same layer as source electrodes of a plurality of oxide thin-film transistors disposed in the plurality of pixels.

According to some embodiments of the present disclosure, each disconnected scan line may include a first portion disposed on one side of the optical hole and a second portion disposed on the other side of the optical hole. Each upper bypass connection line may include a first upper connection portion connected to the first portion of the respective scan line disposed above the centerline of the optical hole, a second upper connection portion connected to the first upper connection portion, a third upper connection portion connected to the second upper connection portion, a fourth upper connection portion connected to the third upper connection portion, and a fifth upper connection portion connected to the fourth upper connection portion and the second portion of the scan line.

According to some embodiments of the present disclosure, the first upper connection portion, third upper connection portion, and fifth upper connection portion may extend in the second direction, and the second upper connection portion and fourth upper connection portion may extend in the first direction.

According to some embodiments of the present disclosure, the first upper connection portion, the third upper connection portion, and the fifth upper connection portion may be disposed on the same layer and above the layer of the respective scan lines. the second upper connection portion and the fourth upper connection portion may be disposed on the same layer and above the layer of the first upper connection portion, the third upper connection portion, and the fifth upper connection portion.

According to some embodiments of the present disclosure, the second upper connection portion and the fourth upper connection portion may be disposed on the same layer as the plurality of data lines in the display area.

According to some embodiments of the present disclosure, the first upper connection portion, the third upper connection portion, and the fifth upper connection portion may be disposed on the same layer as source electrodes of a plurality of oxide thin-film transistors disposed in the plurality of pixels.

According to some embodiments of the present disclosure, the plurality of scan lines may be connected to gate electrodes of a plurality of oxide thin-film transistors disposed in the plurality of pixels.

Although embodiments of the present disclosure have been described in detail with reference to the accompanying drawings, it should be noted that the present disclosure is not necessarily limited to these embodiments and can be modified in various ways without departing from the scope of the technical concept of the invention. Therefore, the embodiments disclosed in the present disclosure are not intended to limit but to describe the technical idea of the present disclosure, and the scope of the technical idea of the specification is not limited by the embodiments. Therefore, it should be understood that the embodiments described above are exemplary and not limited in all aspects.

The present disclosure also includes the following numbered clauses:
Clause 1. A display device, comprising:
   a display panel including a display area with a plurality of pixels, an optical hole within the display area, and a hole bezel area surrounding the optical hole; and
   a plurality of scan lines that supply a scan signal to the plurality of pixels, a first part of a first scan line of the plurality of scan lines extending in a first direction, a second part of the first scan line extending in the first direction and a second direction, and the second part of the first scan line being routed around the hole bezel area.
Clause 2. The display device of clause 1, wherein the first part of the first scan line and the second part of the first scan line are routed above a centerline of the optical hole,
   wherein a first part of a second scan line of the plurality of scan lines extends in the first direction,
   wherein a second part of the second scan line extends in the first direction and the second direction,
   wherein the second part of the second scan line is routed around the hole bezel area and below the centerline of the optical hole, and
   wherein the second part of the first scan line and the second part of the second scan line are symmetrically routed relative to the centerline of the optical hole.
Clause 3. The display device of clause 1, wherein a first part of a second scan line of the plurality of scan lines extends in the first direction,
   wherein a second part of the second scan line extends in the first direction, and
   wherein the second part of the second scan line is routed through the hole bezel area and around the optical hole.
Clause 4. The display device of clause 3, wherein the first part of the second scan line is in a first layer, and
   wherein the second part of the second scan line is in a second layer, the second layer being disposed on the first layer.
Clause 5. The display device of any preceding clause, wherein the second part of the first scan line includes a first bypass portion extending in the second direction and a second bypass portion extending in the first direction.
Clause 6. The display device of clause 5, wherein the first part of the first scan line is in a first layer,
   wherein the second bypass portion is in a second layer, the second layer being disposed on the first layer, and
   wherein the first bypass portion is in a third layer, the third layer being disposed on the second layer.
Clause 7. The display device of any preceding clause, further comprising:
   a plurality of data lines that supply data voltages to the plurality of pixels,
   wherein a first data line of the plurality of data lines includes a first part extending in the second direction and routed outside of the hole bezel area, and
   wherein the first data line further includes a second part routed through the hole bezel area and around the optical hole.
Clause 8. The display device of clause 7, wherein a second data line of the plurality of data lines includes a first part extending in the second direction and routed outside of the hole bezel area,
   wherein the second data line further includes a second part routed through the hole bezel area and around the optical hole,
   wherein the second part of the first data line is in a first layer, and
   wherein the second part of the second data line is in a second layer disposed on the first layer.
Clause 9. The display device of clause 7 or clause 8, wherein the second part of the first scan line includes a first bypass portion extending in the second direction and a second bypass portion extending in the first direction,
   wherein the second bypass portion is in a first layer,
   wherein the first bypass portion is in a second layer disposed on the first layer, and
   wherein the first part of the first data line is in the second layer.

## Claims

1. A display device, comprising:
a display panel including a display area with a plurality of pixels, an optical hole within the display area, and a hole bezel area surrounding the optical hole;
a plurality of scan lines extending in a first direction in the display area and disconnected by the optical hole;
a plurality of bypass connection lines disposed in the display area, the plurality of bypass connection lines connecting disconnected portions of the plurality of scan lines; and
a plurality of data lines extending in a second direction in the display area and passing through the hole bezel area, the second direction intersecting the first direction.

2. The display device of claim 1, wherein the plurality of bypass connection lines comprise:
a plurality of lower bypass connection lines connecting disconnected portions of the plurality of scan lines disposed below a centerline of the optical hole; and
a plurality of upper bypass connection lines connecting disconnected portions of the plurality of scan lines disposed above the centerline of the optical hole.

3. The display device of claim 2, wherein the plurality of lower bypass connection lines and the plurality of upper bypass connection lines are arranged symmetrically relative to the centerline of the optical hole.

4. The display device of claim 2 or claim 3, wherein each scan line of the plurality of scan lines comprises a first portion disposed on a first side of the optical hole and a second portion disposed on a second side of the optical hole, and
wherein each lower bypass connection line of the plurality of lower bypass connection lines comprises a first lower connection portion connected to the first portion of a respective scan line of the plurality of scan lines disposed below the centerline of the optical hole, a second lower connection portion connected to the first lower connection portion, a third lower connection portion connected to the second lower connection portion, a fourth lower connection portion connected to the third lower connection portion, and a fifth lower connection portion connected to the fourth lower connection portion and the second portion of the respective scan line.

5. The display device of claim 4, wherein the first lower connection portion, the third lower connection portion, and the fifth lower connection portion extend in the second direction, and the second lower connection portion and the fourth lower connection portion extend in the first direction.

6. The display device of claim 4 or claim 5, wherein the first lower connection portion, the third lower connection portion, and the fifth lower connection portion are disposed on a same layer and above a layer of the respective scan line, and the second lower connection portion and the fourth lower connection portion are disposed on a same layer and above a layer of the first lower connection portion, the third lower connection portion, and the fifth lower connection portion.

7. The display device of claim 6, wherein the second lower connection portion and the fourth lower connection portion are disposed on the same layer as the plurality of data lines in the display area.

8. The display device of claim 6 or claim 7, wherein the first lower connection portion, the third lower connection portion, and the fifth lower connection portion are disposed on the same layer as source electrodes of a plurality of oxide thin-film transistors disposed in the plurality of pixels.

9. The display device of any one of claims 2 to 8, wherein each scan line of the plurality of scan lines comprises a first portion disposed on a first side of the optical hole and a second portion disposed on a second side of the optical hole, and
wherein each upper bypass connection line of the plurality of upper bypass connection lines comprises a first upper connection portion connected to the first portion of a respective scan line of the plurality of scan lines disposed above the centerline of the optical hole, a second upper connection portion connected to the first upper connection portion, a third upper connection portion connected to the second upper connection portion, a fourth upper connection portion connected to the third upper connection portion, and a fifth upper connection portion connected to the fourth upper connection portion and the second portion of the respective scan line.

10. The display device of claim 9, wherein the first upper connection portion, the third upper connection portion, and the fifth upper connection portion extend in the second direction, and the second upper connection portion and the fourth upper connection portion extend in the first direction.

11. The display device of claim 9 or claim 10, wherein the first upper connection portion, the third upper connection portion, and the fifth upper connection portion are disposed on a same layer and above a layer of the respective scan line, and the second upper connection portion and the fourth upper connection portion are disposed on a same layer and above a layer of the first upper connection portion, the third upper connection portion, and the fifth upper connection portion.

12. The display device of claim 11, wherein the second upper connection portion and the fourth upper connection portion are disposed on the same layer as the plurality of data lines in the display area.

13. The display device of claim 11 or claim 12, wherein the first upper connection portion, the third upper connection portion, and the fifth upper connection portion are disposed on the same layer as source electrodes of a plurality of oxide thin-film transistors disposed in the plurality of pixels.

14. The display device of any preceding claim, wherein the plurality of scan lines are connected to gate electrodes of a plurality of oxide thin-film transistors disposed in the plurality of pixels.
